(19) Europäisches Patentamt
European Patent Office
Office européen des brevets

(11) **EP 4 394 511 A1**

(12) **EUROPEAN PATENT APPLICATION**
published in accordance with Art. 153(4) EPC

(43) Date of publication:
**03.07.2024 Bulletin 2024/27**

(21) Application number: **22861015.0**

(22) Date of filing: **20.07.2022**

(51) International Patent Classification (IPC):
*G03F 7/11* (2006.01)     *B41N 1/12* (2006.01)
*G03F 7/00* (2006.01)     *G03F 7/004* (2006.01)
*G03F 7/033* (2006.01)     *G03F 7/039* (2006.01)
*G03F 7/095* (2006.01)

(52) Cooperative Patent Classification (CPC):
**B41N 1/12; G03F 7/00; G03F 7/004; G03F 7/033;
G03F 7/039; G03F 7/095; G03F 7/11**

(86) International application number:
**PCT/JP2022/028164**

(87) International publication number:
**WO 2023/026724 (02.03.2023 Gazette 2023/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **24.08.2021  JP 2021136046**

(71) Applicant: **Toray Industries, Inc.
Tokyo 103-8666 (JP)**

(72) Inventor: **ABURA, Tsutomu
Okazaki-shi, Aichi 444-8522 (JP)**

(74) Representative: **Mewburn Ellis LLP
Aurora Building
Counterslip
Bristol BS1 6BX (GB)**

(54) **PHOTOSENSITIVE RESIN PRINTING PLATE PRECURSOR**

(57) An object of the present invention is to provide a photosensitive resin printing plate precursor including an infrared-sensitive layer having excellent scratch resistance. The present invention is a photosensitive resin printing plate precursor including: a support; and a photosensitive resin layer, an interlayer, and an infrared-sensitive layer in this order on the support, wherein the interlayer contains a polyvinyl alcohol having a degree of saponification of 60 to 100 mol% and an average degree of polymerization of 1,200 to 3,000.

Processed by Luminess, 75001 PARIS (FR)

**Description**

Technical Field

The present invention relates to a photosensitive resin printing plate precursor.

Background Art

A CTP (computer to plate) technology, which is known as a digital image forming technology, has been common in the fields of letterpress printing and flexographic printing. The CTP technology is a method in which digital data is used to form an image mask on a mask layer element of a photosensitive resin printing plate precursor having the mask layer element, and then, active rays are radiated to a photosensitive resin layer via the image mask, and partially photocure the photosensitive resin layer to form a rugged pattern that is to serve as a relief.

Such a photosensitive resin printing plate precursor suitable for the CTP technology is disclosed, as follows: a photosensitive resin printing plate precursor (see, for example, Patent Literature 1) characterized by including a support and at least a photosensitive resin layer (A) and a water-insoluble thermosensitive mask layer (C) that are laminated in this order on the support, the photosensitive resin layer (A) containing a resin dissolvable or dispersible in water and a monomer curable by ultraviolet rays, and the water-insoluble thermosensitive mask layer (C) containing an infrared absorbing substance, wherein the water permeation time of the thermosensitive mask layer (C) is 50 to 400 seconds; and a water-developable photosensitive letterpress printing precursor (see, for example, Patent Literature 2) characterized by including at least (A) a support, (B) a photosensitive resin layer, (C) an oxygen-blocking division layer, and (D) a water-soluble or water-dispersible thermosensitive mask layer containing carbon black, that are laminated in this order, wherein the (B) photosensitive resin layer contains a synthetic polymer compound, a photopolymerizable unsaturated compound, and a photopolymerization initiator, wherein the synthetic polymer compound contains a polyamide that contains a tertiary nitrogen atom or polyether urea urethane, and wherein the (C) oxygen-blocking division layer contains a polyvinyl alcohol having a degree of saponification of 60 to 85 mol% and a degree of polymerization of 200 to 800.

Citation List

Patent Literature

Patent Literature 1: JP2015-176066A
Patent Literature 2: WO2017-056763

Summary of Invention

Technical Problem

In the above-described technology, a photosensitive resin printing plate precursor having an infrared-sensitive layer such as a thermosensitive mask layer, if caused to receive a scratch on the infrared-sensitive layer during handling, results in having an unnecessary rugged pattern formed on the photosensitive resin layer. Hence, the infrared-sensitive layer needs to have excellent scratch resistance.

An object of the present invention is to provide a photosensitive resin printing plate precursor including an infrared-sensitive layer having excellent scratch resistance.

Solution to Problem

The present invention is a photosensitive resin printing plate precursor including: a support; and a photosensitive resin layer, an interlayer, and an infrared-sensitive layer in this order on the support, wherein the interlayer contains a polyvinyl alcohol having a degree of saponification of 60 to 100 mol% and an average degree of polymerization of 1,200 to 3,000.

Advantageous Effects of Invention

In a photosensitive resin printing plate precursor according to the present invention, the infrared-sensitive layer has excellent scratch resistance.

Description of Embodiments

Embodiments for carrying out the present invention will now be described in detail.

A photosensitive resin printing plate precursor (hereinafter referred to as a "printing plate precursor" for short in some cases) according to the present invention includes a photosensitive resin layer, an interlayer, and an infrared-sensitive layer in this order on a support. The support acts to retain the photosensitive resin layer in the printing plate precursor. When irradiated with active rays via an image mask, the photosensitive resin layer acts to constitute a rugged pattern (relief) corresponding to the image mask. The infrared-sensitive layer, when subjected to infrared rays, acts to partially ablate, thus forming an image mask. The interlayer acts to closely adhere to the photosensitive resin layer and the infrared-sensitive layer therebetween, inhibit a low-molecular-weight component from being transferred from the photosensitive resin layer to the infrared-sensitive layer, and enhance the scratch resistance of the infrared-sensitive layer. Here, "the scratch resistance of the infrared-sensitive layer" means the scratch resistance of the infrared-sensitive layer in the printing plate precursor, unless otherwise specified.

A printing plate precursor according to the present invention may further has an easily-adhesive layer between the support and the photosensitive resin layer, as required, and thus can enhance an adhesive force between the support and the photosensitive resin layer. In addition, the printing plate precursor may have a protective layer on the infrared-sensitive layer, and thus can inhibit the infrared-sensitive layer from being scratched by an external force, and further enhance the scratch resistance of the infrared-sensitive layer in the printing plate precursor.

The printing plate precursor according to the present invention is characterized in that the interlayer contains a polyvinyl alcohol having a degree of saponification of 60 to 100 mol% and an average degree of polymerization of 1,200 to 3,000. Here, the degree of saponification and average degree of polymerization of a polyvinyl alcohol in the present invention are values measured in accordance with JIS K 6726-1994 (Testing methods for polyvinyl alcohol). In addition, in a case where the interlayer contains two or more kinds of polyvinyl alcohols, the degree of saponification and average degree of polymerization of the polyvinyl alcohol means the degree of saponification and average degree of polymerization respectively of the two or more kinds of polyvinyl alcohols as a whole.

Bringing, to 60 mol% or more, the degree of saponification of the polyvinyl alcohol in the interlayer makes it possible to enhance the solubility in a developing solution containing water as a main component. In particular, in a case where the below-described infrared-sensitive layer can be removed with a developing solution containing water as a main component, the photosensitive resin layer, the interlayer, and the infrared-sensitive layer can be developed in combination using the developing solution containing water as a main component. The degree of saponification is preferably 65 mol% or more. On the other hand, the degree of saponification of the polyvinyl alcohol in the interlayer is preferably 97 mol% or less, which can enhance adhesiveness to the photosensitive resin layer.

In addition, in a case where the average degree of polymerization of the polyvinyl alcohol in the interlayer is less than 1,200, the interlayer is prone to be swollen by the transfer of a low-molecular-weight component from the photosensitive resin layer, and thus, is prone to embrittle. When the interlayer is embrittled, the low-molecular-weight component transfers also to the infrared-sensitive layer, decreasing the scratch resistance of the infrared-sensitive layer. The average degree of polymerization is preferably 1,400 or more. On the other hand, bringing, to 3,000 or less, the average degree of polymerization of the polyvinyl alcohol in the interlayer makes it possible to form the interlayer easily.

The thickness of the interlayer is preferably 0.1 to 3 $\mu$m. Bringing the thickness of the interlayer to 0.1 $\mu$m makes it possible to further enhance the scratch resistance of the infrared-sensitive layer. The thickness of the interlayer is more preferably 0.3 $\mu$m or more. On the other hand, bringing the thickness of the interlayer to 3 $\mu$m or less makes it possible to form a relief in which the depth for an image of a recess is large, and to enhance the reproducibility of an image of a reverse type or the like. The thickness of the interlayer is more preferably 2 $\mu$m or less. Here, the thickness of the interlayer in the present invention can be measured by observing a magnified cross section of the printing plate under a transmission electron microscope or a scanning electron microscope. In addition, in a case where the coating amount per unit area is known, the thickness can be calculated from the coating amount and the specific gravity.

Next, the infrared-sensitive layer will be described. The infrared-sensitive layer acts as follows: (1) absorbs an infrared laser beam efficiently, so that the resulting heat evaporates or ablates all or part of the layer to cause a difference in the optical density between a portion irradiated with and a portion not irradiated with the laser beam, that is, to decrease the optical density of the irradiated portion; and (2) blocks ultraviolet light practically. Here, blocking ultraviolet light practically means that the optical density of the infrared-sensitive layer is 2.0 or more. The optical density is more preferably 2.5 or more. The optical density is generally represented by D, and defined by the following formula.

$$D = \log_{10}(100 / T) = \log_{10}(I_0 / I)$$

Here, T is a transmittance (unit: %), $I_0$ is the intensity of incident light at the time when the transmittance is measured, and I is the intensity of transmitted light.

The optical density in the present invention refers to a value calculated from a measurement value of the intensity of transmitted light with incident light set at a given intensity. The optical density can be measured using a Macbeth transmission densitometer "TR-927" (manufactured by Kollmorgen Instruments Corp.), and using an orthochromatic filter.

The infrared-sensitive layer preferably contains an infrared absorbing substance. The infrared-sensitive layer preferably further contains a polyvinyl alcohol.

The infrared absorbing substance is preferably a substance having absorptive characteristics in the range of wavelengths from 750 nm to 20,000 nm. Examples include: black pigments such as carbon black, carbon graphite, and cyanine black; inorganic pigments such as manganese oxide, iron oxide, chromium oxide, and copper chromite; and dyes such as phthalocyanine, substituted phthalocyanine derivatives, cyanine dyes, merocyanine dyes, polymethine dyes, and metal thiolate dyes. Two or more of these may be contained. Among these, carbon black is preferable from the viewpoints of efficiency of ablation and an ultraviolet absorbing capability.

Carbon black preferably has an anionic group. Having an anionic group makes it possible to enhance the dispersibility of carbon black without using a dispersant. The anionic group is preferably a sulfo group or a carboxyl group. A sulfo group has a large dissociation constant in water, and is very effective in inhibiting the aggregation of carbon black in the below-described dispersion liquid of a composition for the infrared-sensitive layer. On the other hand, the carboxyl group can inhibit the aggregation of carbon black, and inhibit a coating defect in the infrared-sensitive layer, in which the aggregation is due to a solvent shock that is prone to occur in a case where an organic solvent such as a lower alcohol is added to the below-described dispersion liquid of a composition for the infrared-sensitive layer.

A carbon black having a carboxyl group as an anionic group preferably has a lactone group. A carboxyl group has a low dissociation constant in water, and is susceptible to the influence of a functional group of another component and a pH. Because of this, a carbon black having a carboxyl group tends to aggregate. Compared with this, having a lactone group having hydrophilicity but not having ionicity has an effect owing to which the lactone group causes steric hindrance in an electrostatic interaction with another component, and inhibits the aggregation. Because of this, a carbon black having a carboxyl group and a lactone group has excellent dispersibility in polyvinyl alcohol, and can inhibit a coating defect in the infrared-sensitive layer.

The amount of the infrared absorbing substance contained in the infrared-sensitive layer is preferably 5 mass% or more in all the solid contents from the viewpoint of enhancing the efficiency of ablation. On the other hand, the amount of the infrared absorbing substance contained in the infrared-sensitive layer is preferably 80 mass% or less from the viewpoint of further enhancing the scratch resistance of the infrared-sensitive layer.

In addition, the infrared-sensitive layer in the present invention preferably contains an ultraviolet absorbing substance that blocks ultraviolet rays. The ultraviolet absorbing substance is preferably a substance having absorptive characteristics in the range of wavelengths from 300 to 400 nm. Examples include benzotriazole-based compounds, triazine-based compounds, benzophenone-based compounds, and the like. Two or more of these may be contained.

The infrared-sensitive layer preferably contains a polyvinyl alcohol, and thus can enhance the dispersibility of the infrared absorbing substance, and enhance the coating forming characteristics of the infrared-sensitive layer. In addition, such an infrared-sensitive layer can enhance the adhesiveness to the above-described interlayer. The polyvinyl alcohol in the infrared-sensitive layer preferably has a degree of saponification of 60 to 100 mol% and an average degree of polymerization of 300 to 3,500. The degree of saponification and degree of polymerization of a polyvinyl alcohol in the infrared-sensitive layer are values measured in accordance with JIS K 6726-1994 (Testing methods for polyvinyl alcohol) in the same manner as those in the interlayer. In addition, in a case where the infrared-sensitive layer contains two or more kinds of polyvinyl alcohols, the degree of saponification and average degree of polymerization of the polyvinyl alcohol means the degree of saponification and degree of polymerization respectively of the two or more kinds of polyvinyl alcohols as a whole.

Bringing, to 60 mol% or more, the degree of saponification of the polyvinyl alcohol in the infrared-sensitive layer makes it possible to enhance the solubility in a developing solution containing water as a main component, and makes it possible that the photosensitive resin layer, the interlayer, and the infrared-sensitive layer are developed in combination using a developing solution containing water as a main component. On the other hand, the degree of saponification of the polyvinyl alcohol in infrared-sensitive layer is preferably 97 mol% or less, which can enhance adhesiveness to the interlayer.

The degree of saponification of the polyvinyl alcohol in the infrared-sensitive layer is preferably larger than the degree of saponification of the polyvinyl alcohol in the interlayer. A compound that has an ethylenic double bond, is a low-molecular-weight component, and is contained in the below-described photosensitive resin layer commonly has large lipophilicity. Using, as the polyvinyl alcohol in the infrared-sensitive layer, a polyvinyl alcohol having a higher degree of saponification than in the interlayer makes it possible to further inhibit the transfer of the compound to the infrared-sensitive layer, and further enhance the scratch resistance of the infrared-sensitive layer. A difference between the degree of saponification of the polyvinyl alcohol in the infrared-sensitive layer and the degree of saponification of the polyvinyl alcohol in the interlayer is preferably 1 mol% or more, more preferably 3 mol% or more.

In addition, bringing, to 300 or more, the average degree of polymerization of the polyvinyl alcohol contained in the infrared-sensitive layer makes it possible to enhance the strength of the coating of the infrared-sensitive layer, and enhance the scratch resistance of the infrared-sensitive layer in production processes. Here, the scratch resistance of the infrared-sensitive layer in production processes means the scratch resistance of the infrared-sensitive layer as an intermediate in the production of a printing plate precursor (for example, in a case where the printing plate precursor has a protective layer, the infrared-sensitive layer is in a laminate of the protective layer and the infrared-sensitive layer). Such characteristics, which are different from the scratch resistance of the infrared-sensitive layer in the above-described printing plate precursor, contribute to enhancing the yield of the production processes of the printing plate precursor. The average degree of polymerization is more preferably 1,000 or more. On the other hand, bringing the average degree of polymerization to 3,500 or less makes it possible to form the infrared-sensitive layer easily. The average degree of polymerization is more preferably 2,500 or less.

The amount of the polyvinyl alcohol in the infrared-sensitive layer is preferably 10 mass% or more in all the solid contents from the viewpoint of forming the infrared-sensitive layer more easily. On the other hand, the amount of the polyvinyl alcohol contained in the infrared-sensitive layer is preferably 80 mass% or less in all the solid contents from the viewpoint of enhancing the efficiency of ablation.

The infrared-sensitive layer may contain another polymer, filler, surfactant, coating assistant, and the like to the extent that the effects of the present invention are not impaired. Examples of the another polymer include a polyacrylic acid, polyester, polyamide, a derivative thereof, and the like. Two or more of these may be contained.

Next, the photosensitive resin layer will be described. The photosensitive resin layer preferably contains at least a binder resin, a compound having an ethylenic double bond, and a photopolymerization initiator. When the photosensitive resin layer is irradiated with light, such as ultraviolet rays, in the form of an image, free radicals are generated from the photopolymerization initiator in the photosensitive resin layer in the exposed portion. The free radicals generated induce radical polymerization between the compounds having an ethylenic double bond, and thus, the cross-linked structure makes it possible to form a relief for obtaining a desired printing image. In a case where the binder resin has an ethylenic double bond, radical polymerization also occurs between the binder resin and the compound having an ethylenic double bond. This advances photocuring further, thus making it possible to enhance the image reproducibility of the printing plate.

Examples of the binder resin include a styrene-butadiene copolymer, polybutadiene latex, styrene-butadiene copolymer latex, acrylonitrile-butadiene copolymer latex, methyl methacrylate-butadiene copolymer latex, polyurethane, cellulose derivative, polyester, polyacrylic acid derivative, polyvinyl acetate, polyvinyl alcohol, polyvinylpyrrolidone, polyamide, and the like. Two or more of these may be used. Polyvinyl alcohol is preferable from the viewpoints of coating forming characteristics, developability with water, and adhesiveness to the interlayer.

The degree of saponification of the polyvinyl alcohol contained in the photosensitive resin layer is preferably 60 to 95 mol%. Bringing, to 60 mol% or more, the degree of saponification of the polyvinyl alcohol in the photosensitive resin layer makes it possible to enhance the solubility in a developing solution containing water as a main component. In particular, in a case where the above-described infrared-sensitive layer can be removed with a developing solution containing water as a main component, the photosensitive resin layer, the interlayer, and the infrared-sensitive layer can be developed in combination using the developing solution containing water as a main component. On the other hand, bringing, to 95 mol% or less, the degree of saponification of the polyvinyl alcohol in the photosensitive resin layer makes it possible to enhance the compatibility with another component in the photosensitive resin layer, and inhibit the transfer of a low-molecular-weight component to another layer. The degree of saponification is preferably 90 mol% or less. The degree of saponification of the polyvinyl alcohol in the photosensitive layer is a value measured in accordance with JIS K 6726-1994 (Testing methods for polyvinyl alcohol) in the same manner as that of the interlayer. In addition, in a case where the photosensitive layer contains two or more kinds of polyvinyl alcohols, the degree of saponification of the polyvinyl alcohol means the degree of saponification of the two or more kinds of polyvinyl alcohols as a whole.

The weight-average molecular weight of the polyvinyl alcohol is preferably 10,000 or more and 200,000 or less. Here, the weight-average molecular weight can be determined by GPC measurement. More specifically, a measurement can be made using a gel permeation chromatograph-multi-angle light scattering photometer manufactured by Wyatt Technology, and using polyethylene oxide and polyethylene glycol as standard samples, under conditions at a column temperature of 40°C and at a flow rate of 0.7 mL/minute.

The polyvinyl alcohol in the photosensitive resin layer preferably has an ethylenic double bond in a side chain. Examples of the group having an ethylenic double bond include a vinyl group, acryloyl group, methacryloyl group, and the like. Two or more of these may be contained.

Examples of a method of introducing an ethylenic double bond into a polyvinyl alcohol include: (1) a method in which a hydroxyl group of a polyvinyl alcohol and an acid anhydride are allowed to react, a reactive group such as a carboxyl group is thus introduced into a side chain of the polymer from the starting point that is the hydroxyl group of the polyvinyl alcohol, and an unsaturated epoxy compound is allowed to react with the reactive group; (2) a method in which a copolymer between a vinyl acetate and an unsaturated carboxylic acid, unsaturated carboxylic acid salt, and/or unsaturated carboxylate ester is partially saponified, and a carboxyl group of this polymer and an unsaturated epoxy compound are allowed to react; and the like.

The ethylenic double bond equivalent of the polyvinyl alcohol is preferably 1,000 g/eq or more and 19,000 g/eq or less. Bringing the ethylenic double bond equivalent to 1,000 g/eq or more makes it possible to suitably inhibit the hardness of the surface of a relief of a printing plate, and further enhance the printing reproducibility. On the other hand, bringing the ethylenic double bond equivalent to 19,000 g/eq or less makes it possible to sufficiently advance the photocuring of a printing face, and enhance the image reproducibility and the printing resistance. Here, in a case where the structure of the polyvinyl alcohol is known, the ethylenic double bond equivalent can be calculated by dividing the theoretical weight per 1 mole by the number of ethylenic double bonds contained in one molecule of polyvinyl acetate partially saponified. The ethylenic double bond equivalent can also be calculated as follows: the number of moles of the ethylenic double bond in the polyvinyl acetate partially saponified is analyzed by $^1$H-NMR, and the weight of the sample used for the analysis is divided by the number of moles of the ethylenic double bond detected.

The amount of the polyvinyl alcohol contained in the photosensitive resin layer is preferably 30 to 85 mass%.

The photosensitive resin layer may contain, together with the above-described polyvinyl alcohol, a binder resin having excellent compatibility with polyvinyl alcohol, such as a resin having a hydrophilic group and/or a binder resin as a polymer the main chain of which itself has water swellability or water solubility. Examples of the hydrophilic group include a carboxyl group, amino group, hydroxyl group, phosphate group, sulfonate group, salt thereof, and the like. Examples of the polymer having a hydrophilic group include a carboxylated styrene butadiene latex, a polymer of an aliphatic conjugated diene having a carboxyl group, an emulsion polymer of an ethylenic unsaturated compound having a phosphate group and/or a carboxyl group, a polyurethane containing a sulfonate group, and the like. In addition, examples of the polymer the main chain of which itself has water swellability or water solubility include a vinyl alcohol-sodium acrylate copolymer, vinyl alcohol-sodium methacrylate copolymer, polyvinylpyrrolidone, polyether-containing polyamide, tertiary-nitrogen-atom-containing polyamide, polyether, cellulose, hydroxyethyl cellulose, hydroxypropyl cellulose, carboxymethyl cellulose, starch, starch-polysodium acrylate grafted product, saponified product of a starch-polyacrylonitrile grafted product, cellulose polyacrylic acid grafted product, partially cross-linked polysodium acrylate, polyethylene glycol, polyethylene glycol derivative, and the like. Two or more of these may be contained. Among these, a tertiary-nitrogen-atom-containing polyamide is preferably used from the viewpoints of a high physical strength, the capability to further enhance the printing resistance, and a balance between strength and solubility in a solvent.

The compound having an ethylenic double bond refers to a compound having an ethylenic double bond, and having a molecular weight of less than 10,000. The molecular weight of the compound having an ethylenic double bond is preferably 2,000 or less.

Examples of the compound having an ethylenic double bond include (meth)acrylates described in WO2017/038970, glycerol di(meth)acrylate, (meth)acrylic acid adduct of propylene glycol diglycidylether, tetrahydrofurfuryl (meth)acrylate, and the like. Two or more of these may be contained. Here, (meth)acrylate is a generic term for an acrylate and a methacrylate, and (meth)acrylic acid is a generic term for an acrylic acid and a methacrylic acid.

In the photosensitive resin layer, the amount of the compound having an ethylenic double bond is preferably 10 to 60 wt%.

The photopolymerization initiator to be preferably used has the capability to absorb light to generate radicals by virtue of autolysis or hydrogen abstraction. Examples include benzoinalkyl ethers, benzophenones, anthraquinones, benzyls, acetophenones, diacetyls, and the like. Two or more of these may be contained.

The amount of the photopolymerization initiator contained in the photosensitive resin layer is preferably 0.1 to 10 mass%.

The photosensitive resin layer may contain a compatibilizing auxiliary, ink-repellent agent, polymerization inhibitor, dye, pigment, surfactant, defoaming agent, ultraviolet absorber, perfume, or the like, as required.

Allowing the photosensitive resin layer to contain a compatibilizing auxiliary makes it possible to enhance the compatibility with components constituting the photosensitive resin layer, inhibit the bleedout of a low-molecular-weight component, and enhance the flexibility of the photosensitive resin layer. Examples of the compatibilizing auxiliary include polyalcohols such as ethylene glycol, diethylene glycol, triethylene glycol, glycerin, trimethylolpropane, trimethylolethane, pentaerythritol, and derivatives thereof. Two or more of these may be contained. The amount of the compatibilizing auxiliary contained in the photosensitive resin layer is preferably 30 mass% or less.

Allowing the photosensitive resin layer to contain an ink-repellent agent makes it possible to inhibit ink from entering a recess of a relief during printing, and enhance the reproducibility. Examples of the ink-repellent agent include a silicone compound, fluorine-containing compound, and the like. Two or more of these may be contained. The amount of the ink-repellent agent contained in the photosensitive resin layer is preferably 5 mass% or less.

Allowing the photosensitive resin layer to contain a polymerization inhibitor makes it possible to enhance the thermal stability. Examples of the polymerization inhibitor include phenols, hydroquinones, catechols, hydroxyamine derivatives, and the like. Two or more of these may be contained. The amount of the polymerization inhibitor contained in the photosensitive resin layer is preferably 0.001 to 5 mass%.

Next, the support will be described. Examples of the support include a plastic sheet composed of polyester or the like, a synthetic rubber sheet composed of styrene-butadiene rubber or the like, metal plate composed of steel, stainless steel, aluminium, or the like, and the like. The thickness of the support is preferably in the range from 100 to 350 $\mu$m from the viewpoints of handleability and flexibility.

The support is preferably treated to become easily-adhesive, thus making it possible to enhance the adhesiveness to a relief or a floor layer. Examples of a method of treatment for easily-adhesieness include a mechanical treatment such as sand blast, physical treatment such as corona discharge, chemical treatment by coating or the like, and the like. Among these, from the viewpoint of adhesion, it is preferable to provide an easily adhesive layer by coating.

A printing plate precursor according to the present invention may have a protective layer on the infrared-sensitive layer, as required.

Examples of the protective layer include a plastic sheet composed of polyester, polyethylene, polypropylene, or the like. The thickness of the protective layer is preferably 10 to 150 $\mu$m from the viewpoints of handleability and flexibility.

Next, a method of producing a printing plate precursor according to the present invention will be described taking, as an example, a case where the support has a photosensitive resin layer, interlayer, infrared-sensitive layer, and protective layer thereon.

For example, a polyvinyl alcohol, a compound component having an ethylenic double bond, and another additive are dissolved in a solvent with heating to obtain a photosensitive resin composition solution. Examples of the solvent include a water/alcohol solvent mixture, and the like.

The photosensitive resin composition solution is cast on the support having an easily-adhesive layer, if desired, and dried to form a photosensitive resin layer. Next, a protective layer having an interlayer and an infrared-sensitive layer formed thereon is made to closely adhere to the photosensitive resin layer, thus making it possible to obtain a printing plate precursor. The protective layer having an interlayer and an infrared-sensitive layer formed thereon is produced, for example, by a method in which, to a protective layer, an infrared-sensitive layer composition dispersion liquid containing the above-described infrared-sensitive layer components is applied and dried, and then, an interlayer composition solution containing the above-described interlayer components is applied and dried.

A method of producing a printing plate using a printing plate precursor according to the present invention will be described. The method preferably includes: an exposure step of partially photocuring the photosensitive resin layer of the printing plate precursor; and a development step of removing an uncured portion of the photosensitive resin layer using a liquid containing water.

In the exposure step, a protective layer, if any, is peeled off from a printing plate precursor, which is attached a digital imager having an infrared laser such as a fiber laser, and the infrared-sensitive layer is ablated to form an image mask. Then, it is preferable that, via the image mask formed from the infrared-sensitive layer, ultraviolet rays having a wavelength from 300 to 400 nm is radiated to the photosensitive resin layer, the exposed portion of which is thereby photocured. Examples of the light source for exposure include a high-pressure mercury lamp, ultrahigh-pressure mercury lamp, metal halide lamp, xenon lamp, carbon arc lamp, chemical lamp, UV-LED lamp, and the like.

In the development step, it is preferable that the photosensitive resin layer in the unexposed portion is removed with a liquid containing water. Examples of the developer include a spray-type developer, brush-type washing machine, and the like.

Furthermore, as required, the development may be followed by a postexposure step including irradiation with ultraviolet rays. The postexposure step makes it possible that an unreacted compound having an ethylenic double bond is allowed to react, making the relief firmer.

A printing plate precursor according to the present invention and a printing plate obtained using the same can be used for letterpress printing, dry offset printing, flexographic printing, and the like, with a label printing rotary press, a semi-rotary rotary press, or the like. Among these, letterpress printing and dry offset printing are more suitable uses.

Examples

The present invention will now be described in detail with reference to Examples.

<Synthesis of Polymer for Photosensitive Resin Layer>

(Synthesis Example 1)

Partially saponified polyvinyl alcohol "Gohsenol" (registered trademark) KL-05 (having an average degree of polymerization of 500, a degree of saponification of 80 mol%, and an Mw of 38,000) manufactured by Mitsubishi Chemical Corporation was swollen in acetone. To 100 parts by mass of the "Gohsenol" KL-05, 4.2 parts by mass of succinic anhydride was added, and the resulting mixture was stirred at 60°C for six hours to add a carboxyl group to the molecular chain. This polymer was washed with acetone to remove unreacted succinic anhydride, and then dried. This polymer in an amount of 100 parts by mass was dissolved in 200 parts by mass of a solvent mixture of ethanol/water at 30/70 (a ratio by weight) at 80°C. To this, 6 parts by mass of glycidyl methacrylate was added, so that an ethylenic double bond was introduced into the partially saponified polyvinyl alcohol to obtain a polymer A solution. The ethylenic double bond equivalent of the polymer A obtained was 5,611 g/eq, and the weight-average molecular weight was 40,000. In this regard, the weight-average molecular weight was measured using a gel permeation chromatograph-multi-angle light scattering photometer manufactured by Wyatt Technology, and using polyethylene oxide and polyethylene glycol as a standard sample, under conditions at a column temperature of 40°C and at a flow rate of 0.7 mL/minute. In addition, the ethylenic double bond equivalent was measured as follows: 30 mg of the polymer A was dissolved in 1 ml of a heavy water/heavy methanol solvent mixture containing sodium 3-(trimethylsilyl)propionate-2, 2, 3, 3d$_4$ added as an internal standard; a $^1$H-NMR measurement was made; and the number of moles of the ethylenic double bond was measured. The ethylenic double bond equivalent was calculated by dividing the polymer A in the sample used for analysis by the number of moles of the ethylenic double bond detected.

(Synthesis Example 2)

In a stainless-steel-made autoclave, 20 parts by mass of ε-caprolactam, 80 parts by mass of nylon salt of *N*-(2-aminoethyl)piperazine and adipic acid, and 100 parts by mass of water were introduced. The air inside was replaced with nitrogen gas. Then, the resulting mixture was heated at 180°C for one hour. Then, water was removed to obtain a polyamide resin (polymer B) having a tertiary amino group, the resin being a water-soluble polyamide resin. With the polymer B obtained, the weight-average molecular weight measured in the same manner as in Synthesis Example 1 was 72,000.

<Production of Support Having Easily-adhesive Layer>

A mixture of 260 parts by mass of "VYLON" (registered trademark) 31SS (a toluene solution of an unsaturated polyester resin, manufactured by Toyobo Co., Ltd.) and 2 parts by mass of PS-8A (benzoinethyl ether, manufactured by Wako Pure Chemical Industries, Ltd.) was heated at 70°C for two hours, and then cooled to 30°C, and 7 parts by mass of ethylene glycol diglycidyl ether dimethacrylate was added and mixed for two hours. Furthermore, 25 parts by mass of "Coronate" (registered trademark) 3015E (an ethyl acetate solution of a polyvalent isocyanate resin, manufactured by Tosoh Corporation) and 14 parts by mass of EC-1368 (an industrial adhesive, manufactured by Sumitomo 3M Limited) were added and mixed to obtain a coating liquid for an easily-adhesive layer.

To "Lumirror" (registered trademark) T60 (a polyester film, manufactured by Toray Industries, Inc.) having a thickness of 250 μm, the coating liquid for an easily-adhesive layer was applied with a bar coater so as to have a thickness of 30 μm when dried. The liquid was heated using an oven at 180°C for three minutes to remove the solvent, and a support having an easily-adhesive layer was thus obtained.

<Preparation of Photosensitive Resin Layer Composition Solution>

To a three-neck flask equipped with a stirring spatula and a cooling tube, the polymers listed in Table 1 were added, and a solvent mixture of 50 parts by mass of "SOLMIX" (registered trademark) H-11 (an alcohol mixture, manufactured by Japan Alcohol Trading Co., Ltd.) and 50 parts by mass of water was added. The resulting mixture was heated with stirring at 90°C for two hours to dissolve the polymers. The resulting mixture was cooled to 70°C, and then, the other components listed in Table 1 were added. The resulting mixture was stirred for 30 minutes to obtain a solution of a photosensitive resin layer composition.

[Table 1]

| | | | Photosensitive resin layer composition |
|---|---|---|---|
| Blending Amount (parts by mass) | Polymer | Polymer A | 45 |
| | | Polymer B | 5 |
| | Compound having ethylenic double bond | 2-hydroxy-3-phenoxypropyl acrylate | 5 |
| | | glycerol dimethacrylate | 15 |
| | | polyalkylene glycol (PEG200) diacrylate | 15 |
| | Photopolymerization initiator | 2,2-dimethoxy-1,1-diphenylethane-1-one | 1.3 |
| | Plasticizer | pentaerythritolpolyoxyethylene ether | 10 |
| | Polymerization inhibitor | N-(ammoniumoxy)-N-nitrosophenylamine | 0.2 |
| | Ultraviolet absorber | 2,4-di-tert-butyl-6-(5-chloro-2H-1,2,3-benzotriazole-2-yl)phenol | 0.02 |

<Preparation of Infrared-sensitive Layer Composition Dispersion Liquid>

An aqueous 5 mass% solution of each of the polyvinyl alcohols listed in Table 2, an aqueous dispersion liquid of 10 mass% carbon black, and 5 parts by mass of "SOLMIX" (registered trademark) H-11 (an alcohol mixture, manufactured by Japan Alcohol Trading Co., Ltd.) were mixed at room temperature to obtain a dispersion liquid of each of the infrared-sensitive layer compositions 1 to 6. The dispersibility of carbon black in a dispersion liquid of each of the infrared-sensitive layer compositions 1 to 6 was good, and an aggregate 2 $\mu$m or more on a grind gauge was not observed.

[Table 2]

| | | | Product Name Characteristics | Infrared-sensitive Layer Composition | | | | | |
|---|---|---|---|---|---|---|---|---|---|
| | | | | 1 | 2 | 3 | 4 | 5 | 6 |
| Blending Amount (parts by mass) | Polyvinyl Alcohol | 1 | AL-06 (manufactured by Mitsubishi Chemical Corporation, having a degree of saponification of 93 mol% and an average degree of polymerization of 600) | 20 | - | - | - | - | - |
| | | 2 | JL-18E (manufactured by Japan Vam & Poval Co., Ltd., having a degree of saponification of 84 mol% and an average degree of polymerization of 1800) | - | 20 | 20 | - | - | - |
| | | 3 | JL-13Y (manufactured by Japan Vam & Poval Co., Ltd., having a degree of saponification of 93 mol% and an average degree of polymerization of 1300) | - | - | - | 20 | - | - |
| | | 4 | JL-22E (manufactured by Japan Vam & Poval Co., Ltd., having a degree of saponification of 80 mol% and an average degree of polymerization of 2200) | - | - | - | - | 20 | - |
| | | 5 | KL-03 (manufactured by Mitsubishi Chemical Corporation, having a degree of saponification of 80 mol% and an average degree of polymerization of 300) | - | - | - | - | - | 20 |
| | Carbon Black | 1 | BONJET BLACK CW-1 (manufactured by Orient Chemical Industries Co., Ltd., containing a carboxyl group and a lactone group) | 10 | 10 | - | 10 | 10 | 10 |
| | | 2 | CAB-O-JET (tm) 200 (manufactured by Cabot Corporation, containing a sulfo group) | - | - | 10 | - | - | - |

The methods of evaluation in Examples and Comparative Examples will now be described below.

<Scratch Resistance of Infrared-sensitive Layer in Protective Layer/Infrared-sensitive Layer Laminate>

From the infrared-sensitive layer/protective layer laminate that was an intermediate obtained in each of Examples and Comparative Examples, a sample 25 cm × 2 cm in size was cut out. A piece of cloth of a carpet material (#4008, manufactured by Shin Nissen Co., Ltd.) was attached to a rubbing finger having an empty weight of 500 g in a fastness tester (RT-300, manufactured by Daiei Kagaku Seiki Mfg. Co., Ltd.). The above-described sample was rubbed in a reciprocated manner 20 times, and then, the infrared-sensitive layer in the surface of the sample was magnified and observed under a microscope (VHX2000, manufactured by Keyence Corporation, with a 100-power lens, with transmitted light). The area of each scratch in the observation field of view was calculated. The ratio of the total area of all the scratches to the area of the observation field of view was calculated. On the basis of the following criteria, the scratch resistance of the infrared-sensitive layer in the protective layer/infrared-sensitive layer laminate was evaluated.

A: the area of scratches accounts for less than 1%.
B: the area of scratches accounts for 1% or more and less than 5%.
C: the area of scratches accounts for 5% or more and less than 10%.
D: the area of scratches accounts for 10% or more.

<Number of Defects in Infrared-sensitive Layer in Protective Layer/Infrared-sensitive Layer Laminate>

A 30 cm × 30 cm area in the infrared-sensitive layer/protective layer laminate that was an intermediate obtained in each Examples and Comparative Examples was magnified and observed using a loupe. The number of coating defects (cissing defects) 200 $\mu$m or more in the infrared-sensitive layer was counted. The smaller the number, the better.

<Scratch Resistance of Infrared-sensitive Layer in Printing Plate Precursor>

The protective layer was peeled off from the printing plate precursor obtained in each of Examples and Comparative Examples. The resulting precursor was stored in an environment at 25°C and 80 RH% for one hour. Then, a sample 25 cm × 2 cm in size was cut out. A piece of cloth of a carpet material (#4008, manufactured by Shin Nissen Co., Ltd.) was attached to a rubbing finger having an empty weight of 500 g in a fastness tester (RT-300, manufactured by Daiei Kagaku Seiki Mfg. Co., Ltd.). The above-described sample was rubbed in a reciprocated manner 2 times, and then, the infrared-sensitive layer in the surface of the sample was magnified and observed under a microscope (VHX2000, manufactured by Keyence Corporation, under a 100-power lens, with transmitted light). The area of each scratch in the observation field of view was calculated. The ratio of the total area of all the scratches to the area of the observation field of view was calculated. On the basis of the following criteria, the scratch resistance of the infrared-sensitive layer in the printing plate precursor was evaluated. C or above was rated acceptable, and C or above was rated acceptable.

A: the area of scratches accounts for less than 1%.
B: the area of scratches accounts for 1% or more and less than 5%.
C: the area of scratches accounts for 5% or more and less than 10%.
D: the area of scratches accounts for 10% or more.

<Reproducibility of Image of Recess>

The protective layer was peeled off from the printing plate precursor obtained in each of Examples and Comparative Examples. The resulting precursor was attached to a rotary cylindrical drum of a digital imager CDI Spark 2530 (manufactured by Esko-Graphics BV) in such a manner that the support side was inward. The precursor was irradiated with a laser beam from a fiber laser under conditions at 4.0 J/cm$^2$, the infrared-sensitive layer was ablated to form an image mask containing a thin line having a width of 300 $\mu$m. Via the image mask formed, UV-LED exposure was performed at 22 W for 360 seconds. Then, the precursor was developed with water of 25°C to 30°C for 100 seconds, using a brush-type developer DX-A3 (manufactured by Takano Machinery Works, Co., Ltd.), and dried at 60°C for 10 minutes to obtain a printing plate.

The image of a recess having a line width of 300 $\mu$m in the printing plate obtained was magnified and observed at a magnification of 25 times under an ultradeep color 3D shape measuring microscope VK-9500 (manufactured by Keyence Corporation). The depth was measured at 5 points each, and the average was calculated. In a case where the depth was 50 $\mu$m or more, the reproducibility of the image of a recess was rated excellent. The reproducibility was rated more excellent in a case where the depth was 70 $\mu$m or more, and extremely excellent in a case where the depth was 80 $\mu$m or more.

[Example 1]

On the easily-adhesive layer of the support obtained by the above-described method, a photosensitive resin layer composition solution was cast, and dried at 60°C for two hours to form a photosensitive resin layer having a thickness of 650 $\mu$m. The thickness of the photosensitive resin layer was adjusted by placing a spacer having a predetermined thickness on the support having an easily-adhesive layer, and scraping out, with a horizontal metal square, the photosensitive resin layer composition solution of the portion protruding.

Onto a "Lumirror" (registered trademark) S10 (a polyester film, manufactured by Toray Industries, Inc.) having a thickness of 100 $\mu$m as a protective layer, the dispersion liquid of the infrared-sensitive layer composition 1, obtained by the above-described method, was applied using a bar coater, and dried at 120°C for 30 seconds to form an infrared-sensitive layer. A protective layer/infrared-sensitive layer laminate was thus obtained. The thickness of the infrared-sensitive layer was adjusted in such a manner that the optical density (in the transmission mode of a Macbeth transmission densitometer "TR-927" (manufactured by Kollmorgen Instruments Corp.)) was 3.0 using an orthochromatic filter with the value for the protective layer set at zero.

In a solvent mixture of 45 parts by mass of water/20 parts by mass of methanol/20 parts by mass of $n$-propanol/10 parts by mass of n-butanol, 5 parts by mass of a polyvinyl alcohol 1 (JL-18E (manufactured by Japan Vam & Poval Co., Ltd., having a degree of saponification of 84 mol% and an average degree of polymerization of 1,800)) was dissolved at 70°C to obtain an interlayer composition solution, which was applied onto the infrared-sensitive layer of the protective layer/infrared-sensitive layer laminate using a bar coater so as to have a thickness of 0.1 $\mu$m when dried. The solution was dried at 120°C for 30 seconds to form an interlayer. Thus, an interlayer/infrared-sensitive layer/protective layer laminate was obtained.

Onto the photosensitive resin layer formed by the above-described method, a solvent mixture of 50 parts by mass of water and 50 parts by mass of ethanol was applied. The interlayer/infrared-sensitive layer/protective layer laminate was laminated in such a manner that the interlayer side is on the photosensitive resin layer. Thus, a printing plate precursor was obtained. The results of the evaluations performed by the above-described methods are shown in Table 3.

[Examples 2 to 5]

A printing plate precursor was obtained in the same manner as in Example 1 except that the thickness of the interlayer was changed as shown in Table 3. The results of the evaluations are shown in Table 3.

[Example 6]

A printing plate precursor was obtained in the same manner as in Example 3 except that the polyvinyl alcohol of the interlayer was changed as shown in Table 3. The results of the evaluations are shown in Table 3.

[Examples 7 to 9]

A printing plate precursor was obtained in the same manner as in Example 2 except that the infrared-sensitive layer was formed with the infrared-sensitive layer composition shown in Table 3. The results of the evaluations are shown in Table 3.

[Example 10]

A printing plate precursor was obtained in the same manner as in Example 9 except that the polyvinyl alcohol of the interlayer was changed as shown in Table 3. The results of the evaluations are shown in Table 3.

[Example 11]

A printing plate precursor was obtained in the same manner as in Example 10 except that the infrared-sensitive layer was formed with the infrared-sensitive layer composition shown in Table 3. The results of the evaluations are shown in Table 3.

[Example 12]

A printing plate precursor was obtained in the same manner as in Example 11 except that the infrared-sensitive layer was formed with the infrared-sensitive layer composition shown in Table 3. The results of the evaluations are shown in Table 3.

[Comparative Example 1]

A printing plate precursor was obtained in the same manner as in Example 9 except that the interlayer was not formed. The results of the evaluations are shown in Table 3.

[Comparative Example 2]

A printing plate precursor was obtained in the same manner as in Example 9 except that the polyvinyl alcohol of the interlayer was changed as shown in Table 3. The results of the evaluations are shown in Table 3.

[Comparative Example 3]

A printing plate precursor was obtained in the same manner as in Example 2 except that the polyvinyl alcohol of the interlayer was changed as shown in Table 3. The results of the evaluations are shown in Table 3.

[Table 3]

| | | | Examples | | | | | | | | | | | | Comparative Examples | | |
|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 1 | 2 | 3 |
| Infrared-sensitive Layer Composition | | | 1 | 1 | 1 | 1 | 1 | 1 | 2 | 3 | 4 | 4 | 5 | 6 | 4 | 4 | 1 |
| Interlayer | Polyvinyl Alcohol | Kind*1 | 1 | 1 | 1 | 1 | 1 | 3 | 1 | 1 | 1 | 3 | 3 | 1 | - | 4 | 2 |
| | | Degree of Saponification, mol% | 84 | 84 | 84 | 84 | 84 | 79 | 84 | 84 | 84 | 79 | 79 | 84 | - | 72 | 88 |
| | | Average Degree of Polymerization | 1,800 | 1,800 | 1,800 | 1,800 | 1,800 | 2,500 | 1,800 | 1,800 | 1,800 | 2,500 | 2,500 | 1,800 | - | 700 | 1,000 |
| | Thickness, $\mu$m | | 0.1 | 0.5 | 1.0 | 3.0 | 3.5 | 1.0 | 0.5 | 0.5 | 0.5 | 0.5 | 0.5 | 0.5 | - | 3.0 | 0.5 |
| Scratch Resistance of Infrared-sensitive Layer in Protective Layer/Thermosensitive Mask Layer Laminate | | | B | B | B | B | B | B | A | A | A | A | A | C | A | A | B |
| Number of Defects of Infrared-sensitive Layer in Protective Layer/Thermosensitive Mask Layer Laminate | | | 0 | 0 | 0 | 0 | 0 | 0 | 0 | 2 | 0 | 0 | 0 | 0 | 0 | 0 | 0 |
| Scratch Resistance of Infrared-sensitive Layer in Printing Plate Precursor | | | C | B | B | B | B | B | B | B | A | A | B | C | D | D | C |
| Reproducibility of Image of Recess Depth, $\mu$m | | | 98 | 88 | 75 | 55 | 45 | 80 | 87 | 88 | 90 | 85 | 84 | 89 | 110 | 56 | 84 |

*1: Polyvinyl alcohol 1: JL-18E (manufactured by Japan Vam & Poval Co., Ltd., having a degree of saponification of 84 mol% and an average degree of polymerization of 1,800)
Polyvinyl alcohol 2: JP-10 (manufactured by Japan Vam & Poval Co., Ltd., having a degree of saponification of 88 mol% and an average degree of polymerization of 1,000)
Polyvinyl alcohol3: JL-25E (manufactured by Japan Vam & Poval Co., Ltd., having a degree of saponification of 79 mol% and an average degree of polymerization of 2,500)
Polyvinyl alcohol4: KP-08R (manufactured by Mitsubishi Chemical Corporation, having a degree of saponification of 72 mol% and an average degree of polymerization of 700)

**Claims**

1. A photosensitive resin printing plate precursor comprising:

   a support; and
   a photosensitive resin layer, an interlayer, and an infrared-sensitive layer in this order on said support,
   wherein said interlayer contains a polyvinyl alcohol having a degree of saponification of 60 to 100 mol% and
   an average degree of polymerization of 1,200 to 3,000.

2. The photosensitive resin printing plate precursor according to claim 1, wherein the thickness of said interlayer is 0.1
   to 3 $\mu$m.

3. The photosensitive resin printing plate precursor according to claim 1 or 2, wherein said infrared-sensitive layer
   comprises a carbon black containing a carboxyl group and/or a sulfo group.

4. The photosensitive resin printing plate precursor according to claim 3, wherein said carbon black comprises a
   carboxyl group and a lactone group.

5. The photosensitive resin printing plate precursor according to any one of claims 1 to 4, wherein said infrared-sensitive
   layer comprises a polyvinyl alcohol having a degree of saponification of 60 to 100 mol% and a degree of polymerization
   of 300 to 3,000.

6. The photosensitive resin printing plate precursor according to any one of claims 1 to 5, wherein the degree of
   saponification of said polyvinyl alcohol in said infrared-sensitive layer is larger than the degree of saponification of
   said polyvinyl alcohol in said interlayer.

7. The photosensitive resin printing plate precursor according to any one of claims 1 to 6, wherein said photosensitive
   resin layer comprises a polyvinyl alcohol and a compound containing an ethylenic double bond.

## INTERNATIONAL SEARCH REPORT

International application No.

**PCT/JP2022/028164**

**A.    CLASSIFICATION OF SUBJECT MATTER**

*G03F 7/11*(2006.01)i; *B41N 1/12*(2006.01)i; *G03F 7/00*(2006.01)i; *G03F 7/004*(2006.01)i; *G03F 7/033*(2006.01)i; *G03F 7/039*(2006.01)i; *G03F 7/095*(2006.01)i
FI:   G03F7/11; G03F7/095; G03F7/00 502; G03F7/004 505; G03F7/033; G03F7/039; B41N1/12

According to International Patent Classification (IPC) or to both national classification and IPC

**B.    FIELDS SEARCHED**

Minimum documentation searched (classification system followed by classification symbols)

G03F7/11; B41N1/12; G03F7/00; G03F7/004; G03F7/033; G03F7/039; G03F7/095

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | WO 2021/039263 A1 (TOYOBO CO., LTD.) 04 March 2021 (2021-03-04) claims, example 1 | 1-2 |
| Y | | 3-7 |
| Y | JP 2014-119594 A (JSR CORP) 30 June 2014 (2014-06-30) paragraph [0061] | 3-4 |
| Y | WO 2010/070918 A1 (ASAHI KASEI E-MATERIALS CORPORATION) 24 June 2010 (2010-06-24) paragraph [0041], example 5 | 5-7 |

☐ Further documents are listed in the continuation of Box C.      ☑ See patent family annex.

| | |
|---|---|
| *     Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **15 August 2022** | **30 August 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2022/028164**

| Patent document cited in search report | | | Publication date (day/month/year) | Patent family member(s) | Publication date (day/month/year) |
|---|---|---|---|---|---|
| WO | 2021/039263 | A1 | 04 March 2021 | (Family: none) | |
| JP | 2014-119594 | A | 30 June 2014 | (Family: none) | |
| WO | 2010/070918 | A1 | 24 June 2010 | US 2011/0275016 A1 paragraph [0100], example 5 CN 102257434 A | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015176066 A
- WO 2017056763 A
- WO 2017038970 A